(19) Europäisches Patentamt / European Patent Office / Office européen des brevets

(11) **EP 1 553 130 B1**

(12) **EUROPEAN PATENT SPECIFICATION**

(45) Date of publication and mention
of the grant of the patent:
**23.06.2010 Bulletin 2010/25**

(21) Application number: **03795433.6**

(22) Date of filing: **12.09.2003**

(51) Int Cl.:
*C08J 9/26* (2006.01)     *C08J 9/28* (2006.01)

(86) International application number:
**PCT/JP2003/011729**

(87) International publication number:
**WO 2004/024808 (25.03.2004 Gazette 2004/13)**

(54) **POROUS MEMBRANE OF POLY(METAPHENYLENE ISOPHTHALAMIDE) AND PROCESS FOR PRODUCING THE SAME**

PORÖSE MEMBRAN AUS POLY(METAPHENYLENISOPHTHALAMID) UND HERSTELLUNGSVERFAHREN DAF R

MEMBRANE POREUSE DE POLY(METAPHENYLENE ISOPHTALAMIDE) ET SON PROCEDE DE PRODUCTION

(84) Designated Contracting States:
**BE DE FR GB NL**

(30) Priority: **12.09.2002   JP 2002266620
19.03.2003   JP 2003075312**

(43) Date of publication of application:
**13.07.2005   Bulletin 2005/28**

(73) Proprietor: **TEIJIN LIMITED
Osaka-shi
Osaka 541-0054 (JP)**

(72) Inventors:
• **SASAKI, Takeshi,
c/o Teijin Limited
Iwakuni-shi, Yamaguchi 740-0014 (JP)**
• **KIDO, Nobuaki,
c/o Teijin Limited
Iwakuni-shi, Yamaguchi 740-0014 (JP)**
• **MATSUMURA, Shunichi,
c/o Teijin Limited
Iwakuni-shi, Yamaguchi 740-0014 (JP)**

(74) Representative: **Hallybone, Huw George et al
Carpmaels & Ransford
43-45 Bloomsbury Square
London WC1A 2RA (GB)**

(56) References cited:
**EP-A- 1 233 036         WO-A1-01/19906
JP-A- 2002 209 822     JP-A- 2002 268 435
JP-A- 2003 201 364**

**Description**

Technical Field

The present invention relates to a porous film composed of poly(metaphenylene isophthalamide) and to a process for its production. The porous film is useful for various precision filters, and for multilayer wiring boards, electronic package substrates and flexible printed boards employing the porous film as a core material.

Background Art

Polyolefins such as polypropylene have conventionally been known for use as porous films. However, because they have poor heat resistance and undergo dimensional changes due to heat shrinkage of their films and pores when used, for example, in situations where the temperature exceeds 180˚C, problems have occurred such as reduction or loss of their function as porous films.

Aromatic polyamides are known as alternative films with excellent heat resistance. Japanese Examined Patent Publication SHO No. 59-14494, for example, describes a process for production of an aromatic polyamide porous film comprising at least 80 mole percent of a metaphenylene isophthalamide unit.

Japanese Examined Patent Publication SHO No. 59-36939 describes a process for production of a porous film made of an aromatic polyamide.

Both of the aforementioned production processes disclose, for most cases, addition of an inorganic salt in the dope or coagulation liquid. Consequently, since trace amounts of the inorganic salts remain in the final porous film product, they are unsuitable as materials for electronic uses.

Porous films formed from aromatic polyamides are often subjected to ordinary stretching treatment to increase the surface open area, but problems have often arisen in such cases depending on the use, such as the problem of increasing mean pore size with stretching treatment.

On the other hand, the rapid development of high-density information technology in recent years has led to an increased demand for dimensional stability, workability, even greater thinness and high densification, and various types of electronic circuit boards have also been desired therefor. In light of these circumstances, new types of base materials employing porous films have been proposed.

Japanese Unexamined Patent Publication No. 2001-345537 and Japanese Unexamined Patent Publication No. 2002-111227 describe examples of porous polyamides as multilayer wiring board materials for electronic packages.

Another use is described, for example, in Japanese Patent Publication No. 2,623,331, wherein a porous plastic film made of an aromatic polyamide is used as a separator for an electrolytic capacitor.

Japanese Unexamined Patent Publication HEI No. 11-250890 discloses the use of a polyamide film with pores as a porous film for a battery separator. Also, International Patent Publication WO01/19906 discloses a poly(metaphenylene isophthalamide) film having a porous structure.

Disclosure of the Invention

It is an object of the present invention to provide a novel porous film made of poly(metaphenylene isophthalamide).

It is another object of the invention to provide a porous film made of poly(metaphenylene isophthalamide), wherein the porous film has a high surface open area.

It is yet another object of the invention to provide a porous film made of poly(metaphenylene isophthalamide) wherein the porous film has a controlled surface open area and a highly uniform porosity.

It is still another object of the invention to provide a porous film having the aforementioned characteristics, which is suitable for electronic circuits or separators.

It is still another object of the invention to provide a process for production of a novel porous film made of poly (metaphenylene isophthalamide) which has a specified surface open area.

Other objects and advantages of the present invention will become apparent from the explanation presented below.

According to the invention, these objects and advantages are achieved, firstly, by:

[1] A porous film possessing at least two surfaces and comprising a plurality of connected pores, wherein the porous film

(1) consists substantially of poly(metaphenylene isophthalamide),
(2) has an open area of 20-70% on both of two surfaces of the porous film,

(3) has a difference 0-40% in the open areas of two surfaces,
(4) has a mean pore size of 0.1-10 $\mu$m on both of two surfaces, and
(5) has a porosity of 30-90%.

The objects and advantages of the invention are achieved, secondly, by:

[2] A process for production of a porous film which is a production process for a porous film possessing at least two surfaces and comprising a plurality of connected pores, wherein a polymer solution containing poly(metaphenylene isophthalamide) and an amide solvent is subjected to the following steps (i) to (iv) in order:

(i) a casting step of casting onto a support,
(ii) a dipping coagulation step wherein the cast solution layer is dipped in an amide coagulation liquid containing a substance which is non-compatible with poly(metaphenylene isophthalamide) for coagulation of the cast solution layer,
(iii) a washing and releasing step wherein the coagulated layer obtained in the previous step is washed and released, or released while washing, from the support, and
(iv) a heat treatment step wherein the washed and released coagulated layer film is heat treated.

Brief Description of the Drawings

Fig. 1 is an illustrative diagram of an electronic package substrate.
Fig. 2 is an example of an SEM photograph showing the cross-section of a porous film of the invention as seen from the top, the bottom and diagonally.
Fig. 3 is a cross-sectional view of an SEM photograph for a comparative example.

Explanation of Symbols

1: IC chip
2: Resin
3: Bump
4: Package substrate
5: Terminal

Best Mode for Carrying Out the Invention

A first embodiment of the porous film of the invention will now be explained.

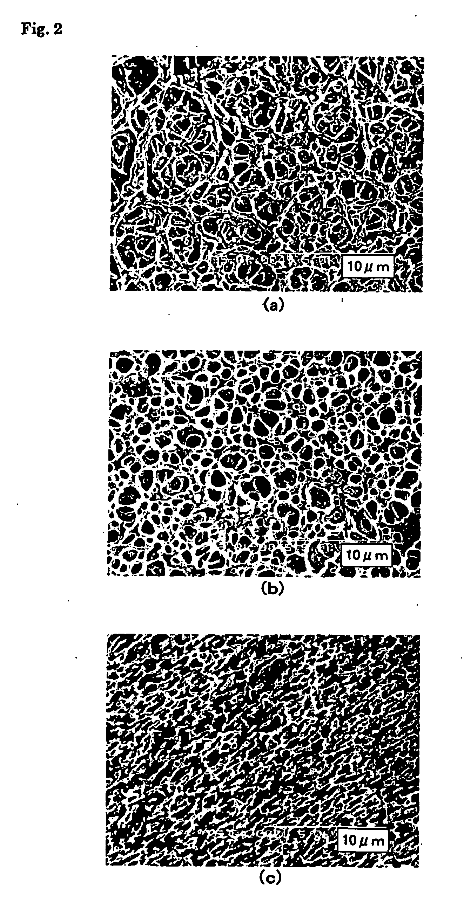

The porous film of the invention is in an ordinary film or sheet form and possesses at least two surfaces. As shown in Fig. 2, for example, a plurality of pores are present in both surfaces and the pores are connected to form a connected porous structure.

The poly(metaphenylene isophthalamide) of which the porous film of the invention is composed is, substantially, a polymer obtained by polycondensation wherein a meta-aromatic diamine and a meta-aromatic dicarboxylic acid halide are reacted in substantially equimolar amounts. It may also be a copolymerized polymer wherein the meta-aromatic diamine is replaced with another amine component such as a para-aromatic diamine, aliphatic diamine or alicyclic diamine in an amount of no greater than 20 mole percent with respect to the amount of the meta-aromatic diamine used. Also included are copolymerized polymers comprising alternative dicarboxylic acid components such as a para-aromatic dichloride, aliphatic dicarboxylic acid or alicyclic dicarboxylic acid in an amount of no greater than 20 mole percent with respect to the amount of the meta-aromatic dicarboxylic acid halide used. The term "substantially" is used in this sense.

As examples of meta-aromatic diamines there may be mentioned 1,3-phenylenediamine, 1,6-naphthalenediamine, 1,7-naphthalenediamine, 2,7-naphthalenediamine and 3,4'-biphenyldiamine.

As meta-aromatic dicarboxylic acid halides there may be mentioned dicarboxylic acid dihalides of, for example, isophthalic acid, 1,6-naphthalenedicarboxylic acid, 1,7-naphthalenedicarboxylic acid and 3,4-biphenyldicarboxylic acid.

Among these, using 1,3-phenylenediamine as the meta-aromatic diamine or an isophthalic acid dihalide as the meta-aromatic dicarboxylic acid halide will provide advantages in terms of properties of the obtained porous film and cost. Particularly suitable is a combination of 1,3-phenylenediamine and an isophthalic acid dihalide.

Specific examples of copolymerizing monomers for the other amine component include para-aromatic diamines such as para-phenylenediamine, 4,4'-diaminobiphenyl, 2-methyl-para-phenylenediamine, 2-chloro-para-phenylenediamine, 2,6-naphthalenediamine and 3,4'-diaminodiphenylether.

Specific examples of copolymerizing monomers for the other dicarboxylic acid component include dicarboxylic acid dihalides such as terephthalic acid chloride, biphenyl-4,4'-dicarboxylic acid chloride, 2,6-naphthalenedicarboxylic acid chloride, etc. as para-aromatic dicarboxylic acid dichlorides, aliphatic diamines such as hexanediamine, decanediamine, dodecanediamine, ethylene diamine and hexamethylenediamine, or dicarboxylic acid dihalides such as ethylenedicarboxylic acid, hexamethylenedicarboxylic acid or the like as aliphatic dicarboxylic acids. These diamines and dicarboxylic acid halides may be used alone, or in combinations of two or more.

The poly(metaphenylene isophthalamide) of the invention is preferably a polymer having an inherent viscosity in the range of 0.8-2.5 dl/g and preferably 1.0-2.2 dl/g, as expressed by the following formula (1):

$$\text{Inherent viscosity (units: dL/g)} = \ln(T/T_0)/C \qquad (1)$$

If the inherent viscosity is lower than 0.8 dl/g it is not possible to achieve sufficient film strength, while if it is higher than 2.5 dl/g it becomes difficult to obtain a stable polymer solution, and a homogeneous porous film cannot be achieved.

The definitions of T, To and C in formula (1) above are as follows.

T: Flow time for a solution of 0.5 g of poly(metaphenylene isophthalamide) in 100 mL of N-methyl-2-pyrrolidone as measured with a capillary viscometer at 30°C.
$T_0$: Flow time for N-methyl-2-pyrrolidone as measured with a capillary viscometer at 30°C.
C: Polymer concentration in polymer solution (g/dL)

The porous film of the invention is characterized by having a surface open area of 20-70% on both the front and back sides. According to the invention it was found, surprisingly, that specifying a range not only for the size of the pores on both sides of the porous film and the porosity of the porous film, but also for the proportion of surface pores on both sides of the porous film can result in efficient impregnation of the resin and water in the porous film.

The porous film of the invention has a surface open area of at least 20% on two surfaces, i.e. both the front and back sides, and therefore liquids, resins and the like impregnate into the porous film uniformly in a short time. The limit of 70% is preferred in order to maintain the strength of the porous film. The surface open area is more preferably 20-65% and even more preferably 25-60%. The surface open area can be calculated by image processing of a surface photograph taken by SEM observation or the like.

The difference between the surface open areas on one side of the porous film and the other side is in the range of 0-40%. Generally speaking, a smaller difference will improve the impregnation rate (also referred to as "impregnation efficiency") mentioned above, and therefore the difference in the open areas on both sides is preferably 0-20%.

The porous film of the invention has a mean pore size of 0.1-10 $\mu$m on both surfaces. If the mean value is outside of this range, the impregnation rate (impregnation efficiency) mentioned above will be insufficient and the strength will be inadequate. The pore size is therefore preferred to be as uniform as possible, as this is particularly advantageous from the standpoint of impregnation rate, strength and gas permeability. The mean pore size on both sides is preferably 0.1-3 $\mu$m. A size of less than 3 $\mu$m is preferred to allow adaptation to fine pitching of wiring when the use is, for example, as a core material for a package substrate.

The porous film of the invention has a porosity of 30-90%.
The porosity represents the proportion of voids in the porous film, and is calculated by the following formula (2):

$$\text{Porosity (\%)} = (1-\rho_f/\rho_0) \times 100 \qquad (2)$$

($\rho_f$: apparent density of porous film; $\rho_0$: true density of polymer used).

Porosity is preferably 50% or greater for expression of the function as a porous film, and preferably no greater than 90% in order to maintain strength of the porous film. The porosity is more preferably 55-85% and even more preferably 60-80%.

The gas permeability according to the invention is the value measured according to JIS P8117. The porous film of the invention preferably has a gas permeability of 0-3600 sec/100 cc. The gas permeability is preferably not greater than 3600 sec/100 cc for use as a filter, a base material for a separator or prepreg, or a core material for an electronic package substrate, because the connected structure of the pores will be insufficient. The preferred range for the gas permeability will differ depending on the purpose of use and the environment of use, and for example, when the use is as a core material for an electronic package substrate, it is preferably in the range of 10-3600 sec/100 cc and more preferably in the range of 10-2000 sec/100 cc.

The porous film of the invention preferably has 0-300 sec/$\mu$L permeability of water through at least one side, and more preferably 0-300 sec/$\mu$L permeability of water through both sides. Since the permeability of liquid through the porous film of the invention is poorer for liquids with high surface tension, limiting the permeability for water, which has a high surface tension, to 300 sec/$\mu$L will ensure satisfactory permeability for other liquids as well. The water permeability may be evaluated by dropping 1 $\mu$L of a wet tension test liquid with a surface tension of 730 $\mu$N/cm according to JIS K6768 onto both sides of the porous film allowed to stand for 24 hours or longer in an environment at 23°C, 50% RH, and measuring the time until the test liquid completely permeates into the porous film. The water permeability is preferably not greater than 300 sec/$\mu$L, because more time will be required for liquids to evenly impregnate to the interior of the porous film, while it will can also be difficult to achieve uniform impregnation.

A preferred range for the water permeability will differ depending on the purpose of use and the environment of use, and for example, when the use is as a base material for a prepreg or as a core material for an electronic package substrate, the water permeability is preferably in the range of 1-300 sec/$\mu$L and more preferably in the range of 1-200 sec/$\mu$L.

The porous film of the invention has a gas permeability of no greater than 3600 sec/100 cc, a surface open area of 10-70% and a porosity of 50-90% on the front and back sides and a water permeability of no greater than 300 sec/$\mu$L on both sides, although these will depend on the purpose of use.

A process for production of the aforementioned porous film according to the second invention will now be explained.

The porous film of the invention may be produced by a process for production of a porous film which is a production process for a porous film possessing at least two surfaces and comprising a plurality of connected pores, wherein a polymer solution containing poly(metaphenylene isophthalamide) and an amide solvent is subjected to the following steps (i) to (iv) in order:

(i) a spreading step of casting onto a support,
(ii) a dipping coagulation step wherein the cast solution layer is dipped in an amide coagulating solution containing a substance which is non-compatible with poly(metaphenylene isophthalamide) for coagulation of the cast solution layer,
(iii) a washing and releasing step wherein the coagulated layer obtained in the previous step is washed and released, or released while washing from the support, and
(iv) a heat treatment step wherein the washed and released coagulated layer is heat treated.

For the porous film of the invention, the aforementioned poly(metaphenylene isophthalamide) (A) (hereinafter also referred to as "polymer") is first dissolved in an amide solvent (B) to prepare a polymer solution (C) (hereinafter referred to as "dope"). Next, the dope is cast onto a support to produce a cast solution layer on the support. The cast solution layer is then dipped in an amide coagulating solution for coagulation of the cast solution layer. Finally, the solidified cast solution layer is released from the support while washing and then heat treated.

<Dope production step>

According to the invention, the polymer (A) is dissolved in the amide solvent (B) which is capable of dissolving the polymer, to prepare a dope (C). The temperature for dissolution is not particularly limited so long as it is below the boiling point of the amide solvent (B) used, and it may be, for example, from -20°C to 200°C.

The concentration of the polymer (A) in the dope (C) is preferably 3-30 wt% and more preferably 5-20 wt%. If the dope concentration is outside of the range of 3-30 wt%, the uniformity of the porous film thickness will be impaired and productivity may be reduced.

The amide solvent (B) used may be, for example, a polar amide solvent containing amide groups, such as N-methyl-2-pyrrolidone, N,N-dimethylacetamide or N,N-dimethylformamide. However, the solvent is not particularly restricted to these, and any solvent is suitable so long as the object of the invention is not prevented. Techniques for adding inorganic salts to dopes are known in the prior art, as mentioned above, but since no inorganic salt is used according to the present invention, the resulting porous film will contain substantially no inorganic salt. Consequently, the porous film of the invention may be appropriately used for electrical and electronic purposes.

Adding to the dope (C) at least one type of polyhydric alcoholic substance ($D_1$) and/or C5-19 hydrocarbon ($D_2$) which is soluble in the amide coagulating solution described hereunder is preferred to allow control of the liquid permeability and surface open area of the porous film of the invention.

As the polyhydric alcoholic substance ($D_1$) there is preferably used one which has at least two hydroxyl groups in the molecule and dissolves to 1 wt% or greater in the coagulating solution at a temperature of 30°C. As examples of specifically preferred compounds there may be mentioned diol compounds such as ethylene glycol, diethylene glycol and propylene glycol, polymers such as polyethylene glycol, polypropylene glycol and polyhydroxyalkyl (meth)acrylate and their copolymers, glycerin and its derivatives, and the like. Among these, polyethylene glycol and polyhydroxyalkyl methacrylate are particularly preferred in terms of easier control of the surface open area of the obtained porous film. As compounds having at least two hydroxyl groups in the molecule there may be mentioned polyvinyl alcohol and ethylenevinyl alcohol copolymer, but these compounds are not preferred because they are virtually insoluble in amide-based coagulating solutions at 30°C and thus leave large residue of the polymer in the porous film, thus lowering the heat resistance of the porous film.

The content of the polyhydric alcoholic substance ($D_1$) in the dope (C) is preferably no greater than 100 parts by weight, more preferably no greater than 50 parts by weight, even more preferably no greater than 20 parts by weight and especially no greater than 10 parts by weight to 100 parts by weight of the polymer. This is because a polyhydric alcoholic substance ($D_1$) content of greater than 100 parts by weight will tend to leave residue of the polyhydric alcoholic substance ($D_1$) in the resulting porous film, thereby lowering the heat resistance of the porous film. The polyhydric alcoholic substance ($D_1$) is added for the purpose of controlling the physical properties of the porous film, and therefore its addition will not always be necessary, depending on the purpose of use. Consequently, while there is no particular restriction on the lower limit of its content, it will normally be at least 0.01 part by weight to 100 parts by weight of the polyhydric alcoholic substance ($D_1$).

The C5-19 hydrocarbon ($D_2$) is an aliphatic hydrocarbon or aromatic hydrocarbon. From the standpoint of easier control of the surface open area of the obtained porous film, it is preferred to use an aliphatic hydrocarbon. From the standpoint of compound stability and economy, a saturated hydrocarbon is preferably used. Examples of specific preferred compounds include cyclohexane, decane, dodecane, tetradecane, hexadecane, octadecane and liquid paraffin.

These compounds may be used alone or in any combinations of two or more. The C5-19 hydrocarbon may also contain a small amount of a C20 or greater compound, in which case the latter must constitute no more than 40 wt% of the total hydrocarbon. At greater than 40 wt%, the surface contacting the coagulating solution tends to be rough, making it difficult to obtain a homogeneous porous film. The proportion is more preferably no greater than 20 wt%.

The content of the hydrocarbon ($D_2$) in the dope (C) is preferably 0.01-10 wt%. An amount of less than 0.01 wt% will lower the open area of the surface of the porous film in contact with the support base, while an amount of greater than 10 wt% will lower the open area of the surface of the porous film in contact with the coagulateing solution, thus making it impossible to achieve the object of the invention. The range is more preferably 0.1-8 wt% and even more preferably 0.3-5 wt%.

(i) <Casting step>

In the production process of the invention, the dope (C) is subsequently cast onto a support. As examples of supports there may be mentioned glass panels, steel belts, drums or polymer films of polypropylene, polyethylene terephthalate or the like. From the standpoint of productivity, a polymer film is preferably used. Such polymer films may also be subjected to release treatment with silicon, etc. or corona discharge treatment, or the like.

It was found, surprisingly, that subjecting the support to rubbing treatment is effective for accomplishing the object of the invention. Rubbing treatment involves rubbing in one direction with a cloth or the like, and such rubbing treatment allows control of the open area of the surface of the porous film in contact with the support surface.

The rubbing pressure and number of times for rubbing may be appropriately selected as the conditions for rubbing treatment. The preferred range for the rubbing pressure is 10-1000 g/cm², with 100-800 g/cm² being more preferred. A rubbing pressure of less than 10 g/cm² may result in an insufficient rubbing effect. A rubbing pressure of greater than 1000 g/cm² may increase damage to the support, while also hastening wear of the rubbing cloth itself. There is no particular restriction on the number of times for rubbing, and it may be appropriately selected to obtain the desired open area for the porous film.

The temperature of the dope (C) cast onto the support is not particularly restricted. However, the dope viscosity is important in terms of film formation and because it affects the properties of the resulting porous film. The viscosity is preferably selected between 1-2000 Poise and more preferably selected between 5-500 Poise. In order to maintain a sheet-like form of the cast solution layer, it is effective when carrying out the invention to select the atmospheric temperature of the support and its surroundings, and to adjust the atmosphere surrounding the support by blasting or the like. The atmospheric temperature will depend on the type of polymer used, the dope viscosity and the dope concentration, but in most cases will be in the range of 5-50°C.

(ii) Dipping coagulation step

The cast solution layer is then promptly dipped into an amide coagulating solution for coagulation of the cast solution layer.

Examples of specific amide solvents to be used for the amide coagulating solution include N-methyl-2-pyrrolidone, N,N-dimethylacetamide and N,N-dimethylformamide, which may also be used in combinations of two or more. From the viewpoint of control of the porous structure, N-methyl-2-pyrrolidone is preferably used at 100% as the amide solvent.

The amide coagulating solution contains a compound which is substantially incompatible with the polymer (A). Such a compound is one which is inert with respect to the polymer (A) and amide solvent, and which is basically compatible with the amide solvent. As examples of such compounds there may be mentioned water, lower alcohols, lower ethers and the like, which may also be used in combinations of two or more. Using water alone is particularly advantageous from the standpoint of film properties of the obtained porous film, and economy.

The concentration of the amide solvent (for example, 100% N-methyl-2-pyrrolidone) in the amide coagulating solution, in the case of a mixed solution with water, for example, is 50-80 wt%, more preferably 50-70 wt% and even more preferably 55-70 wt% with respect to the total coagulating solution. If the amide solvent concentration is less than 50 wt%, the open area of the porous film surface will tend to be reduced, and the gas permeability and water permeability will tend to be lower. If the concentration is greater than 80 wt%, more time will be required to obtain an independent porous film, and the productivity will therefore be undesirable.

The temperature of the amide coagulating solution is preferably a relatively low temperature, with a lower limit of, for example, -20°C, preferably -10°C and more preferably 0°C. The upper limit is preferably 80°C and more preferably 60°C. Depending on the use, however, this limit may be set to no higher than +25°C, and more preferably between -10°C and +20°C. Formation of the film with a coagulateing solution temperature of between -20°C and +25°C will yield a polymer porous film with satisfactory water permeability.

If the temperature is below -20°C with an amide solvent concentration of less than 50 wt%, the number of pores in the produced polyamide porous film surface will be reduced, while the pore sizes will also tend to be smaller, tending to yield a polyamide porous film with a low open area. If the concentration is greater than 80% and the temperature exceeds 80°C, the pore sizes will tend to be larger and it will often be impossible to obtain a porous film of the invention. If either of the temperature or concentration exceeds the ranges specified above, disadvantages may result depending on the use, although not as much as when both are outside of the specified ranges.

The time for dipping of the cast solution layer in such an amide coagulating solution is not particularly restricted but will normally be from 10 seconds to 60 minutes. If the dipping time is too short the internal structure of the porous film becomes inhomogeneous, and it is preferably not too long from the standpoint of productivity.

In order to confer higher temperature heat resistance to the porous film of the invention, the obtained coagulated layer is preferably crystallized after the dipping coagulation step. The crystallization method is not particularly restricted, but a method of dipping in the aforementioned amide coagulating solution is preferred from the standpoint of productivity.

When such a crystallization step is employed, the concentration of the amide solvent in the dipping treatment bath is preferably 50-80 wt% and more preferably 60-70 wt%. The temperature is preferably 40-98°C and more preferably 50-90°C. If the concentration of the amide solvent in the dipping treatment bath is greater than 80 wt%, the polyamide porous film will sometimes dissolve leading to breakdown of the porous structure, while a concentration of less than 50 wt% may result in insufficient crystallization. A dipping treatment bath temperature of below 40°C will either prevent or hamper crystallization of the polyamide porous film, while a temperature of above 98°C is undesirable as it will tend to cause dissolution of the polyamide porous film and breakdown of the porous structure. The dipping treatment time may be appropriately determined in consideration of the resulting film properties and productivity, but in order to achieve the object of the invention, the treatment time is preferably selected so that the heat of fusion of the porous film after heat treatment in the final step is in the range of 10-80 J/g as measured with a differential scanning calorimeter (DSC) at 10°C/min. For example, when the poly(metaphenylene isophthalamide) is produced from meta-phenylene isophthalamide and isophthalic chloride, dipping treatment for between 30 seconds and 60 minutes can adjust the heat of dissolution to within the aforementioned ranges.

The cast solution layer dipped in the amide coagulation solution will be discharged from both surfaces of the cast solution layer by dissolution, etc. of the amide solvent from the surface of the cast solution layer in the coagulating solution. At the same time, pores are formed by infiltration of the non-compatible compound in the coagulating solution into the cast solution layer. Presumably, the interior of the cast solution layer solidifies almost simultaneously with formation of the porous structure having connected pores. In this case, the sizes and shapes of the pores and the interior porous structure are assumed to change depending on the polymer concentration, dope concentration, dope composition, support material, amide coagulating bath composition and concentration, dipping time, temperature, etc. These conditions may be appropriately determined according to the desired properties for the final porous film product.

The solidified porous cast solution layer is then conveyed to a washing step where it is washed with water. The washing temperature is not particularly restricted since there is virtually no effect on the pore shapes.

(iv) Heat treatment step

The washed porous cast solution layer is then dried in a heat treatment step (drying step). The drying method is not particularly restricted, and may be any method from drying by nip roll treatment for simple draining, to thorough heat drying with a hot air drier or the like.

The crystallized porous film can become brittle depending on the drying conditions, and therefore in the washing and releasing step and/or heat treatment step it is important to achieve 5-30% shrinkage in terms of area ratio based on the area at release of the porous film from the support. The shrinkage is preferably not less than 5% because the obtained porous film may be extremely brittle and difficult to handle, possibly leading to breakage of the porous film in the heat treatment step after the drying step, while the shrinkage is also preferably not greater than 30% because shrinkage irregularities may be produced, making it impossible to obtain a homogeneous porous film. A more preferred range for the shrinkage is 10-25%.

The porous film of the invention obtained in this manner may be subjected to an additional final stage of heat treatment in order to confer dimensional stability against heat. The heat treatment conditions for an amorphous porous film preferably include a temperature of 200-300˚C. Heat treatment at below 200˚C is not preferred because the effect of improved dimensional stability will be reduced, and heat treatment at above 300˚C is not preferred because the glass transition temperature of the polymer will be exceeded, resulting in breakdown of the porous structure. A more preferred temperature range is 240-280˚C. The conditions for heat treatment of a crystalline porous film preferably include a temperature of 200-380˚C. Heat treatment at below 200˚C is not preferred because the effect of improved dimensional stability will sometimes be reduced, and heat treatment at above 380˚C is not preferred because decomposition of the polymer may occur. A more preferred temperature range is 240-340˚C. The heat treatment time may be appropriately determined in consideration of the obtained film properties and productivity and is not particularly restricted, but it may be selected so that the heat of fusion is in the range of 10-80 J/g as measured with a differential scanning calorimeter (DSC) at 10˚C/min, as mentioned above. The treatment time will normally be about 5-60 minutes.

The crystalline porous film produced in this manner preferably has a heat shrinkage of 0-0.7% when treated at 260˚C for 10 minutes. This represents dimensional stability at high temperature, and can be achieved by the range for heat of fusion described above. The heat shrinkage when treated at 260˚C for 10 minutes is preferably low, and it is more preferably no greater than 0.6% and even more preferably no greater than 0.5%.

Effect of the Invention

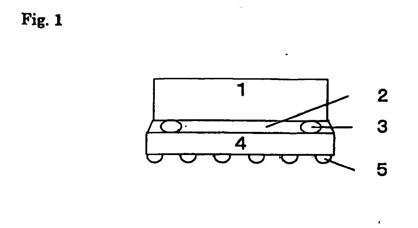

According to the invention, there is provided a porous film having excellent dynamic strength and heat resistance, as well as satisfactory substance permeability. Since the porous film is easily impregnated with various liquids, it can be used, for example, as a prepreg by impregnation of a curing resin such as an epoxy resin. It is also useful as a core material for multilayer wiring boards, electronic package substrates and the like, and for various precision filters. Needless to mention, two or more porous films according to the invention may also be laminated for use. Fig. 1 shows a conceptual diagram for a method of use as a core material for an electronic package substrate.

Examples

The present invention will now be explained through the following examples, with the understanding that the invention is not limited in any way to these examples. The measurement methods for the porous films were as follows.

(1) Surface open area

A surface photograph at 2000x magnification observed with a scanning electron microscope with a resolving power of 4-7 nm was developed to 150 mm vertical x 200 mm horizontal, and a scanner was used at a resolution of 100,000 pixels/30,000 mm$^2$, and the number of pixels for each pore with a diameter of 0.01 $\mu$m or greater was calculated, recording the total as the number of pixels of the open portion. The surface open area was determined by the following formula.

$$\text{Surface open area} = \text{Total pore pixels}/100{,}000 \text{ pixels} \times 100 \ (\%)$$

(2) Mean pore size

A surface photograph at 2000x magnification observed with a scanning electron microscope with a resolving power of 4-7 nm was developed to 150 mm vertical x 200 mm horizontal, and a scanner was used at a resolution of 100,000 pixels/30,000 mm$^2$, the number of pixels for each pore with a diameter of 0.01 $\mu$m or greater was calculated, and the total was divided by the number of pores to determine the mean pore area, from which the diameter was calculated for a perfect circle.

(3) Porosity

The dried porous film was cut to a size of A (mm) x B (mm), and the thickness C (mm) and weight D (g) were measured (with appropriate selection of A, B, C and D). The apparent density E was then determined by the formula shown below. The true density F of the polymer was also determined and the porosity was calculated by the formula shown below.

$$\textbf{Apparent density E = D/(A x B x C) x 1000 (g/cm}^3\textbf{)}$$

$$\textbf{Porosity = (F-E)/F x 100 (\%)}$$

(4) Gas permeability

The time for permeation of 100 cc of air at a pressure of 0.879 g/mm$^2$ was determined according to JIS P8117, and expressed as the Gurley number.

(5) Tensile test

The test was conducted at a pull speed of 10 mm/min in an atmosphere of 23˚C, 50% RH according to JIS K7110, and the tensile strength, breaking elongation and Young's modulus were measured.

(6) Heat shrinkage

The heat shrinkage was determined by treatment at 260˚C for 10 minutes, according to JIS K7133.

(7) Inherent viscosity (IV)

A 0.5 g portion of the polymer was dissolved in 100 mL of N-methyl-2-pyrrolidone, and a capillary viscometer was used to determine the inherent viscosity at 30˚C.

$$\textbf{Inherent viscosity (units: dL/g) = ln(T/T}_0\textbf{)/C} \qquad \textbf{(1)}$$

T: Flow time for the polymer solution as measured with a capillary viscometer at 30˚C.
$T_0$: Flow time for N-methyl-2-pyrrolidone as measured with a capillary viscometer at 30˚C.
C: Polymer concentration in the polymer solution (g/dL)

(8) Water permeability

After dropping 1 $\mu$L of a wet tension test liquid with a surface tension of 730 pN/cm according to JIS K6768 onto the front and back sides of the porous film which had been allowed to stand for 24 hours or longer in an environment at 23˚C, 50% RH, the time until the test liquid completely permeated into the porous film was measured.

(9) Evaluation of impregnation

Approximately 5 $\mu$L of an epoxy resin solution was dropped onto the surface of the porous film at room temperature, and the condition of impregnation into the porous film was visually examined and evaluated on the following scale. The epoxy resin used was "DER" 736 by Dow Corp.

○: Uniform impregnation immediately after dropping
Δ: Non-uniform but gradual impregnation
×: Virtually no impregnation

Poly(metaphenylene isophthalamide) (CONEX by Teijin Techno Products Co., Ltd.) was used as the polymer in all of the examples, and its inherent viscosity (IV) was 1.4 with measurement at a polymer concentration of 0.5 g/dL and a temperature of 30°C, with NMP (N-methyl-2-pyrrolidone) as the solvent. When sulfuric acid was used as the solvent and measurement was conducted under the same conditions, the IV was 1.8. This will hereinafter be referred to as "Conex polymer".

[Example 1]

A porous film was produced under the conditions shown in Table 1, in the following manner.

The Conex polymer was dissolved in N-methyl-2-pyrrolidone and the poly(metaphenylene isophthalamide) concentration was adjusted to 10 wt%. The dope was cast onto a polypropylene film (rubbed 30 times with a contact pressure of 140 g/cm$^2$) to a thickness of 140 $\mu$m. The cast solution layer was then introduced for 5 minutes into a 15°C coagulating bath comprising 60 wt% N-methyl-2-pyrrolidone and 40 wt% water to obtain a coagulated layer. The coagulated layer was released from the polypropylene film and dipped into a 50°C water bath for 30 minutes. The coagulated layer was then treated at 120°C for 30 minutes and subsequently at a temperature of 270°C for 30 minutes to obtain a poly(metaphenylene isophthalamide) porous film.

The properties of the porous film are shown in Table 1 and indicate a relatively high surface open area and satisfactory gas permeability. The tensile strength was 22 MPa, the breaking elongation was 62% and the Young's modulus was 750 MPa, indicating satisfactory dynamic strength. The heat shrinkage was 0.8%, and therefore the porous film had very excellent dimensional stability. The impregnation and permeability for water were also high. The epoxy resin impregnation of the porous film was also excellent. It is therefore expected to have satisfactory adhesion with copper foil and to be useful for a prepreg.

[Example 2]

A porous film was produced according to Example 1, under the conditions shown in Table 1.

The properties of the obtained porous film are shown in Table 1. As in Example 1, the liquid permeability, impregnation and dynamic properties were excellent.

The epoxy resin impregnation was also good, indicating satisfactory adhesion with copper foil, for use as a prepreg.

[Example 3]

Exactly the same procedure was carried out as in Example 1 and the cast solution layer was introduced into a coagulating bath to prepare a coagulated layer. The coagulated layer was then released from the polypropylene film, and fixed to a metal frame to prevent shrinkage of the coagulated layer. It was then introduced for 30 minutes into a 65°C coagulating bath comprising 50 wt% N-methyl-2-pyrrolidone and 50 wt% water. The coagulated layer was removed from the metal frame and dipped in a 50°C water bath for 30 minutes. Upon completion of dipping, the shrinkage was 9.8% in terms of area ratio. The coagulated layer was then dried at 120°C for 30 minutes. At this point, the shrinkage was 19% in terms of area ratio. Treatment was then carried out at a temperature of 280°C for 30 minutes to obtain a porous film.

The thickness of the obtained porous film was 55 $\mu$m, the porosity was 70%, the open area of the front side (the side not contacting the polypropylene film) was 30%, the open area of the back side (the side contacting the polypropylene film) was 37%, the mean pore size on the front side was 1.0 $\mu$m, the mean pore size on the back side was 0.7 $\mu$m and the heat of fusion was 32 J/g. The gas permeability was 160 sec/100 cc, indicating satisfactory gas permeability, the tensile strength was 25 MPa, the breaking elongation was 32% and the Young's modulus was 1050 MPa, indicating satisfactory dynamic strength. Also, the heat shrinkage upon treatment at 260°C for 10 minutes was 0.40%, and therefore the porous film had very excellent dimensional stability.

The porous film had excellent liquid permeability and impregnation. The epoxy resin impregnation was also good, indicating satisfactory adhesion with copper foil, for use as a prepreg.

[Example 4]

The Conex polymer was dissolved in N-methyl-2-pyrrolidone, after which cyclohexane (special grade, product of Wako Pure Chemical Industries) was added, and the poly(metaphenylene isophthalamide) concentration was adjusted to 10 wt% and the cyclohexane concentration was adjusted to 2 wt%. The dope was cast onto a polypropylene film to a thickness of 140 $\mu$m. The cast solution layer was then introduced for 5 minutes into a 5˚C coagulating bath comprising 58 wt% N-methyl-2-pyrrolidone and 42 wt% water to obtain a coagulated layer. The coagulated layer was released from the polypropylene film and dipped into a 50˚C water bath for 30 minutes. After completion of the dipping, the coagulated layer was treated at 120˚C for 30 minutes and subsequently at a temperature of 270˚C for 30 minutes to obtain a porous film.

An electron microscope photograph (SEM photograph) of this porous film is shown in Fig. 2. Fig. 2(a) shows the surface condition on one side of the porous film (the side not in contact with the polypropylene film). Fig. 2(b) shows the surface condition on the other side of the porous film (the side formed in contact with the polypropylene film). Fig. 2(c) shows the interior structure of the porous film as seen from a slant.

All of the surfaces had pores with approximately uniform pore sizes across the entire surface. The interior structure was also a uniform porous structure with a plurality of connected pores.

The properties of the obtained porous film are listed in Table 1. As in the previous examples, the liquid permeability, impregnation and dynamic properties were excellent.

The epoxy resin impregnation was also good, indicating satisfactory adhesion with copper foil, for use as a prepreg.

[Example 5]

The Conex polymer was dissolved in N-methyl-2-pyrrolidone, after which polyethylene glycol (weight-average molecular weight: 1000, product of Wako Pure Chemical Industries) was added for adjustment of the poly(metaphenylene isophthalamide) concentration to 10 wt% and the polyethylene glycol concentration to 0.5 wt%, to prepare a dope. The dope was cast onto a polypropylene film to a thickness of 100 $\mu$m, and then introduced for 10 minutes into a 0˚C coagulating bath comprising 60 wt% N-methyl-2-pyrrolidone and 40 wt% water. The coagulated layer was then released from the polypropylene film and dipped into a 30˚C water bath for 30 minutes to obtain a coagulated layer. The coagulated layer was treated at 120˚C for 30 minutes and subsequently at a temperature of 270˚C for 30 minutes to obtain a porous film.

The properties of the obtained porous film are listed in Table 1. Specifically, the porous film had a thickness of 42 $\mu$m, a porosity of 66%, an open area on the front side (the side not contacting the polypropylene film) of 25%, an open area on the back side (the side contacting the polypropylene film) of 43%, a mean pore size on the front side of 1.1 $\mu$m and a mean pore size on the back side of 1.0 $\mu$m. The gas permeability was 266 sec/100 cc, indicating satisfactory gas permeability. The tensile strength was 28 MPa, the breaking elongation was 53% and the Young's modulus was 850 MPa, indicating satisfactory dynamic strength. Also, the water permeability was 80 sec/$\mu$L on the front side and 75 sec/$\mu$L on the back side, and therefore the porous film had excellent liquid permeability.

The epoxy resin impregnation was also good, indicating satisfactory adhesion with copper foil, for use as a prepreg.

[Example 6]

A porous film was produced according to Example 5, under the conditions shown in Table 1. (Weight-average molecular weight: 2 million, product of Wako Pure Chemical Industries.)

The properties of the obtained porous film are shown in Table 1. As in Example 5, the liquid permeability, impregnation and dynamic properties were excellent.

The epoxy resin impregnation was also good, indicating satisfactory adhesion with copper foil, for use as a prepreg.

[Example 7]

A porous film was produced according to Example 5, under the conditions shown in Table 1.

The properties of the obtained porous film are shown in Table 1. As in Example 5, the liquid permeability, impregnation and dynamic properties were excellent. (PHEMA: poly(2-hydroxyethyl methacrylate) (Viscosity-average molecular weight: 300,000, product of Aldrich.)

The epoxy resin impregnation was also good, indicating satisfactory adhesion with copper foil, for use as a prepreg.

[Example 8]

A porous film was produced according to Example 5, under the conditions shown in Table 1.

The properties of the obtained porous film are shown in Table 1. As in Example 5, the liquid permeability, impregnation and dynamic properties were excellent. (EG: ethylene glycol)

The epoxy resin impregnation was also good, indicating satisfactory ,adhesion with copper foil, for use as a prepreg.

Table 1

| Film forming conditions | Example | | 1 | 2 | 3 | 4 | 5 | 6 | 7 | 8 | Comp. Ex. 1 | Comp.Ex. 2 |
|---|---|---|---|---|---|---|---|---|---|---|---|---|
| | Dope conc. | wt% | 10 | 8 | 10 | 10 | 10 | 10 | 10 | 10 | 8 | 10 |
| | Dope viscosity (30°C) | poise | 220 | 120 | 220 | 215 | 220 | 220 | 220 | 220 | 120 | 220 |
| | Additive | | - | - | - | cyclohexane | PBG1000 | PEG 2 million | PHEMA | EG | - | - |
| | Addition | wt% | - | - | - | 2 | 0.5 | 0.05 | 0.1 | 2 | - | - |
| | Support | | PP rubbing | PP rubbing | PP rubbing | PP | PP | PP | PP | PP | PP | PP |
| | Coating thickness | μm | 140 | 60 | 140 | 100 | 100 | 100 | 100 | 100 | 100 | 200 |
| | Coagulating solution | NMP% | 60 | 55 | 60 | 58 | 60 | 60 | 60 | 60 | 40 | 55 |
| | | °C | 15 | 15 | 15 | 5 | 0 | 20 | 20 | 0 | 30 | 30 |
| | | min | 5 | 5 | 5 | 5 | 10 | 5 | 5 | 10 | 5 | 10 |
| | Crystallization | NMP% | - | - | 50 | - | - | - | - | - | - | - |
| | | °C | - | - | 65 | - | - | - | - | - | - | - |
| | | min | - | - | 30 | - | - | - | - | - | - | - |
| | Water bath | °C | 50 | 50 | 50 | 50 | 30 | 30 | 30 | 30 | 50 | 50 |
| | | min | 30 | 30 | 30 | 30 | 30 | 30 | 30 | 30 | 30 | 30 |
| | Heat treatment 1 | °C | 120 | 120 | 120 | 120 | 120 | 120 | 120 | 120 | 120 | 130 |
| | | min | 30 | 30 | 30 | 30 | 30 | 30 | 20 | 30 | 30 | 30 |
| | Heat treatment 2 | °C | 270 | 270 | 280 | 270 | 270 | 270 | 270 | | - | - |
| | | min | 30 | 30 | 30 | 30 | 30 | 30 | 30 | - | - | - |

(continued)

| | Example | | 1 | 2 | 3 | 4 | 5 | 6 | 7 | 8 | Comp. Ex. 1 | Comp.Ex. 2 |
|---|---|---|---|---|---|---|---|---|---|---|---|---|
| Film evaluation | Film thickness | μm | 50 | 15 | 55 | 39 | 42 | 45 | 50 | 41 | 38 | 60 |
| | Porosity % | | 76 | 63 | 70 | 70 | 66 | 66 | 72 | 68 | 83 | 70 |
| | Front open area | ± | 30 | 63 | 30 | 51 | 25 | 26 | 24 | 30 | 9 | 25 |
| | Back open area | % | 37 | 40 | 37 | 38 | 43 | 27 | 25 | 38 | 10 | 10 |
| | Front pore diameter | μm | 1.4 | 1 | 1 | 0.8 | 1.1 | 1 | 1.2 | 1.6 | 1 | 1.6 |
| | Back pore diameter | μm | 0.8 | 0.5 | 0.7 | 1.2 | 1 | 0.7 | 0.7 | 0.9 | 0.4 | 0.7 |
| | Permeability (Gurley value) | sec/ 100cc | 130 | 15 | 160 | 145 | 266 | 300 | 250 | 180 | 42 | 100 |
| | Tensile strength | Mpa | 22 | 32 | 25 | 25 | 28 | 27 | 25 | 27 | 6.1 | - |
| | Breaking elongation | % | 62 | 55 | 32 | 45 | 53 | 55 | 60 | 55 | 6.4 | - |
| | Yong's modulus | Mpa | 750 | 1300 | 1050 | 880 | 850 | 890 | 820 | 860 | 234 | - |
| | Heat shrinkage | % | 0.8 | 0.8 | 0.4 | 0.85 | - | - | - | - | - | - |
| | DSC | J/g | - | - | 32 | - | - | - | - | - | - | - |
| | Front water permeability | sec/μL | 143 | - 120 | 165 | 176 | 80 | 72 | 120 | 60 | 240 | 155 |
| | Back water permeability | sec/μL | 95 | 135 | 148 | 160 | 75 | 68 | 150 | 60 | 253 | 350 |

14

EP 1 553 130 B1

| Example | 1 | 2 | 3 | 4 | 5 | 6 | 7 | 8 | Comp. Ex. 1 | Comp.Ex. 2 |
|---|---|---|---|---|---|---|---|---|---|---|
| Epoxy resin impregnation | ○ | ○ | ○ | ○ | ○ | ○ | ○ | ○ | Δ | Δ |

Front: Side produced not in contact with polypropylene film
Back: Side produced in contact with polypropylene film

[Comparative Example 1]

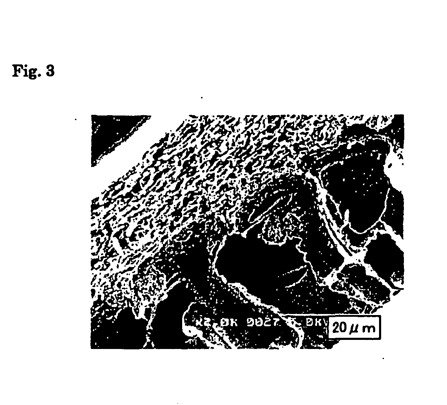

A porous film was produced under the conditions shown in Table 1. The specific procedure was as follows.
The Conex polymer was dissolved in N-methyl-2-pyrrolidone and the poly(metaphenylene isophthalamide) concentration was adjusted to 8 wt%. The dope was cast onto a polypropylene film to a thickness of 100 $\mu$m. The cast solution layer was then introduced for 5 minutes into a 30°C coagulating bath comprising 60 wt% N-methyl-2-pyrrolidone and 40 wt% water to produce a coagulated layer. The coagulated layer was released from the polypropylene film and dipped into a 50°C water bath for 30 minutes. The coagulated layer was then treated at 120°C for 30 minutes to obtain a porous film. The SEM photograph of a cross-section of the porous film (Fig. 3) shows that the interior structure of the porous film was extremely non-uniform.
The properties of the porous film are listed in Table 1, and they indicate a high porosity. However, the surface open area was extremely low and the gas permeability was also low, indicating a satisfactory gas transmission rate. The breaking elongation and Young's modulus were small, indicating weak dynamic strength. The epoxy resin impregnation was also inadequate.

[Comparative Example 2]

A porous film was produced under the conditions shown in Table 1. The specific procedure was as follows.
The Conex polymer was dissolved in N-methyl-2-pyrrolidone and the poly(metaphenylene isophthalamide) concentration was adjusted to 10 wt%. The dope was cast onto a polypropylene film to a thickness of 200 $\mu$m. The cast solution layer was then introduced for 10 minutes into a 10°C coagulating bath comprising 55 wt% N-methyl-2-pyrrolidone and 45 wt% water to produce a coagulated layer. The coagulated layer was released from the polypropylene film and dipped into a 50°C water bath for 30 minutes. The coagulated layer was then treated at 130°C for 30 minutes to obtain a porous film.
The properties of the porous film are listed in Table 1 and indicate a high porosity. However, the surface open area was considerably low on the back side (the side in contact with the polypropylene film), the water permeability was low, and the epoxy resin impregnation was also inadequate.

Industrial Applicability

According to the present invention, the porous film comprising poly(metaphenylene isophthalamide) and having a plurality of connected structures in its interior is characterized by having a specific open area, a difference in open areas on both sides within a specified range and a mean pore size and porosity within specific ranges on both surfaces, thereby exhibiting excellent permeability and impregnation for substances such as air and water and excellent dynamic strength. The porous film is therefore useful for filters, and for curing resin-impregnated prepregs, multilayer wiring boards, electronic package substrates and the like employing it as a core material.

**Claims**

1. A porous film possessing at least two surfaces and containing a plurality of connected pores, wherein the porous film

    (1) consists essentially of poly(metaphenylene isophthalamide),
    (2) has an open area of 20-70% on both of two surfaces of the porous film,
    (3) has a difference 0-40% in the open areas of two surfaces,
    (4) has a mean pore size of 0.1-10 $\mu$m on both of two surfaces, and
    (5) has a porosity of 30-90%.

2. A porous film according to claim 1, wherein a water permeability is 0-300 sec/$\mu$L for penetration from at least one surface.

3. A porous film according to claim 1, wherein the difference in the open areas of two surfaces is 0-20%.

4. A porous film according to claim 1, wherein a heat of fusion is 10-80 J/g as measured by DSC at 10°C/min.

5. A porous film according to claim 4, wherein a heat shrinkage is 0-0.7% upon treatment at 260°C for 10 minutes.

6. A porous film according to claim 1, which has a thickness of 5-100 $\mu$m.

7. A porous film according to claim 1, which contains substantially no inorganic salt.

8. A porous film according to claim 1, wherein a value of a gas permeability measured according to JIS P8117 is 0-3600 sec/100 cc.

9. A process for producing a porous film according to claim 1, which is a production process for a porous film possessing at least two surfaces and containing a plurality of connected pores, wherein a polymer solution containing poly (metaphenylene isophthalamide) and an amide solvent is subjected to the following steps (i) to (iv) in order:

(i) a casting step of casting onto a support,
(ii) a dipping coagulation step wherein the cast solution layer is dipped in an amide coagulating solution containing a substance which is non-compatible with poly(metaphenylene isophthalamide) for coagulation of the cast solution layer, and
wherein the temperature of the amide coagulating solution is between -20˚C and +25 ˚C,
(iii) a washing and releasing step wherein the coagulated layer obtained in the previous step is washed and released, or released while washing from the support, and
(iv) a heat treatment step wherein the washed and released coagulated layer is heat treated.

10. A process for producing a porous film according to claim 1, which is a production process for a porous film possessing at least two surfaces and containing a plurality of connected pores, wherein a polymer solution containing poly (metaphenylene isophthalamide), an amide solvent and at least one compound selected from groups of a polyhydric alcohol substance and/or a C5-19 hydrocarbon which is soluble in an amide coagulating solution is subjected to the following steps (i) to (iv) in order:

(i) a casting step of casting onto a support,
(ii) a dipping coagulation step wherein the cast solution layer is dippsed in an amide coagulating solution containing a substance which is non-compatible with poly(metaphenylene isophthalamide) for coagulation of the cast solution layer,
(iii) a washing and releasing step wherein the coagulated layer obtained in the previous step is washed and released, or released while washing from the support, and
(iv) a heat treatment step wherein the washed and released coagulated layer is heat treated.

11. A process for producing a porous film according to claim 1, which is a production process for a porous film possessing at least two surfaces and containing a plurality of connected pores, wherein a polymer solution containing poly (metaphenylene isophthalamide) and an amide solvent is subjected to the following steps (i) to (iv) in order:

(i) a casting step of casting onto a support,
(ii) a dipping coagulation step wherein the cast solution layer is dipped in an amide coagulating solution containing a substance which is non-compatible with poly(metaphenylene isophthalamide)for coagulation of the cast solution layer,
(iii) a washing and releasing step wherein the coagulated layer obtained in the previous step is washed and released, or released while washing from the support, and
(iv) a heat treatment step wherein the washed and released coagulated layer is heat treated,

wherein the support surface is subjected to rubbing treatment before the polymer solution is cast onto the support.

12. A process for production of a porous film according to claim 11, wherein the pressure for rubbing treatment which is applied onto the support is 10-1000 g/cm$^2$.

13. A process for production of a porous film according to one of claims 9-11, wherein step (ii) is followed by a step of dipping in the amide coagulating solution with the cast solution layer in a coagulated state and then heat treatment, for crystallization of the coagulated layer.

14. A process for production of a porous film according to claim 13, wherein the coagulated layer is caused to shrink 5-30% in terms of area ratio in the crystallization step.

15. A process for production of a porous film according to one of claims 9-11, wherein the amide coagulating solution comprises N-methyl-2-pyrrolidone and water which is incompatible with poly(metaphenylene isophthalamide), and the N-methyl-2-pyrrolidone constitutes 50-80 wt% of the total amide coagulating solution.

**16.** An electronic package substrate comprising a porous film according to claim 1 as the core material.

**17.** Use of a porous film according to claim 1 as the core material for an electronic package substrate.

**Patentansprüche**

**1.** Poröser Film, der mindestens zwei Oberflächen aufweist und eine Vielzahl von verbundenen Poren enthält, wobei der poröse Film

(1) im Wesentlichen aus Poly(metaphenylenisophthalamid) besteht,
(2) eine offene Fläche von 20 bis 70% auf beiden der zwei Oberflächen des porösen Films aufweist,
(3) einen Unterschied in den offenen Flächen der zwei Oberflächen von 0 bis 40% aufweist,
(4) eine mittlere Porengröße von 0,1 bis 10 $\mu$m auf beiden der zwei Oberflächen aufweist, und
(5) eine Porosität von 30 bis 90% aufweist.

**2.** Poröser Film nach Anspruch 1, wobei eine Wasserdurchlässigkeit für das Eindringen von mindestens einer Oberfläche 0 bis 300 s/$\mu$l beträgt.

**3.** Poröser Film nach Anspruch 1, wobei der Unterschied in den offenen Flächen der zwei Oberflächen 0 bis 20% beträgt.

**4.** Poröser Film nach Anspruch 1, wobei eine Schmelzwärme, gemessen durch DSC bei 10°C/min, 10 bis 80 J/g beträgt.

**5.** Poröser Film nach Anspruch 4, wobei eine Wärmeschrumpfung unter Behandlung bei 260°C für 10 Minuten 0 bis 0,7% beträgt.

**6.** Poröser Film nach Anspruch 1, der eine Dicke von 5 bis 100 $\mu$m aufweist.

**7.** Poröser Film nach Anspruch 1, der im Wesentlichen kein anorganisches Salz enthält.

**8.** Poröser Film nach Anspruch 1, wobei ein Wert einer Gasdurchlässigkeit, gemessen gemäß JIS P8117, 0 bis 3600 s/100 cm$^3$ beträgt.

**9.** Verfahren zur Herstellung eines porösen Films nach Anspruch 1, welches ein Herstellungsverfahren für einen porösen Film ist, der mindestens zwei Oberflächen aufweist und eine Vielzahl von verbundenen Poren enthält, wobei eine Polymerlösung, die Poly(metaphenylenisophthalamid) und ein Amid-Lösungsmittel enthält, den folgenden Schritten (i) bis (iv) der Reihe nach unterworfen wird:

(i) einem Gießschritt des Gießens auf einen Träger,
(ii) einem Tauchkoagulationsschritt, wobei die gegossene Lösungsschicht in eine Amid-Koagulationslösung, die eine Substanz enthält, welche nicht mit Poly(metaphenylenisophthalamid) kompatibel ist, eingetaucht wird, um die gegossene Lösungsschicht zu koagulieren, und wobei die Temperatur der Amid-Koagulationslösung zwischen -20°C und +25°C liegt,
(iii) einem Wasch- und Abtrennschritt, wobei die im vorstehenden Schritt erhaltene koagulierte Schicht gewaschen und von dem Träger abgetrennt wird, oder von dem Träger während des Waschens abgetrennt wird, und
(iv) einem Wärmebehandlungsschritt, wobei die gewaschene und abgetrennte koagulierte Schicht wärmebehandelt wird.

**10.** Verfahren zur Herstellung eines porösen Films nach Anspruch 1, welches ein Herstellungsverfahren für einen porösen Film ist, der mindestens zwei Oberflächen aufweist und eine Vielzahl von verbundenen Poren enthält, wobei eine Polymerlösung, die Poly(metaphenylenisophthalamid), ein Amid-Lösungsmittel und mindestens eine Verbindung, ausgewählt aus Gruppen einer Polyolsubstanz und/oder eines C5- bis C19-Kohlenwasserstoff, die in einer Amid-Koagulationslösung löslich ist, enthält, den folgenden Schritten (i) bis (iv) der Reihe nach unterworfen wird:

(i) einem Gießschritt des Gießens auf einen Träger,

(ii) einem Tauchkoagulationsschritt, wobei die gegossene Lösungsschicht in eine Amid-Koagulationslösung, die eine Substanz enthält, welche nicht mit Poly(metaphenylenisophthalamid) kompatibel ist, eingetaucht wird, um die gegossene Lösungsschicht zu koagulieren,

(iii) einem Wasch- und Abtrennschritt, wobei die im vorstehenden Schritt erhaltene koagulierte Schicht gewaschen und von dem Träger abgetrennt wird, oder von dem Träger während des Waschens abgetrennt wird, und

(iv) einem Wärmebehandlungsschritt, wobei die gewaschene und abgetrennte koagulierte Schicht wärmebehandelt wird.

**11.** Verfahren zur Herstellung eines porösen Films nach Anspruch 1, welches ein Herstellungsverfahren für einen porösen Film ist, der mindestens zwei Oberflächen aufweist und eine Vielzahl von verbundenen Poren enthält, wobei eine Polymerlösung, die Poly(metaphenylenisophthalamid) und ein Amid-Lösungsmittel enthält, den folgenden Schritten (i) bis (iv) der Reihe nach unterworfen wird:

(i) einem Gießschritt des Gießens auf einen Träger,

(ii) einem Tauchkoagulationsschritt, wobei die gegossene Lösungsschicht in eine Amid-Koagulationslösung, die eine Substanz enthält, welche nicht mit Poly(metaphenylenisophthalamid) kompatibel ist, eingetaucht wird, um die gegossene Lösungsschicht zu koagulieren,

(iii) einem Wasch- und Abtrennschritt, wobei die im vorstehenden Schritt erhaltene koagulierte Schicht gewaschen und von dem Träger abgetrennt wird, oder von dem Träger während des Waschens abgetrennt wird, und

(iv) einem Wärmebehandlungsschritt, wobei die gewaschene und abgetrennte koagulierte Schicht wärmebehandelt wird,

wobei die Trägeroberfläche, bevor die Polymerlösung auf den Träger gegossen wird, einer Reibbehandlung unterworfen wird.

**12.** Verfahren zur Herstellung eines porösen Films nach Anspruch 11, wobei der Druck zur Reibbehandlung, der auf den Träger angewendet wird, 10 bis 1000 g/cm$^2$ beträgt.

**13.** Verfahren zur Herstellung eines porösen Films nach einem der Ansprüche 9 bis 11, wobei Schritt (ii) ein Schritt des Eintauchens mit der gegossenen Lösungsschicht in einem koagulierten Zustand in die Amid-Koagulationslösung und anschließend Wärmebehandlung folgt, um die koagulierte Schicht zu kristallisieren.

**14.** Verfahren zur Herstellung eines porösen Films nach Anspruch 13, wobei die koagulierte Schicht, bedingt durch den Kristallisationsschritt, um 5 bis 30% bezüglich des Flächenverhältnisses schrumpft.

**15.** Verfahren zur Herstellung eines porösen Films nach einem der Ansprüche 9 bis 11, wobei die Amid-Koagulationslösung N-Methyl-2-pyrrolidon und Wasser umfasst, welches nicht mit Poly(metaphenylenisophthalamid) kompatibel ist, und das N-Methyl-2-pyrrolidon 50 bis 80 Gewichtsprozent der gesamten Amid-Koagulationslösung bildet.

**16.** Elektronikbaugruppe-Substrat, umfassend einen porösen Film nach Anspruch 1 als das Kernmaterial.

**17.** Verwendung eines porösen Films nach Anspruch 1 als das Kernmaterial für ein Elektronikbaugruppe-Substrat.

**Revendications**

**1.** Film poreux possédant au moins deux surfaces et contenant une pluralité de pores reliés, lequel film poreux

(1) est essentiellement constitué de poly(métaphénylène isophtalamide),
(2) a une surface de vide de 20 à 70 % sur les deux surfaces du film poreux,
(3) a une différence de surface de vide comprise entre 0 et 40 % entre les deux surfaces,
(4) a une taille de pore moyenne de 0,1 à 10 $\mu$m sur les deux surfaces, et
(5) a une porosité de 30 à 90 %.

**2.** Film poreux selon la revendication 1, dans lequel la perméabilité à l'eau est comprise entre 0 et 300 s/$\mu$L pour la pénétration par au moins une surface.

3. Film poreux selon la revendication 1, dans lequel la différence de surface de vide entre les deux surfaces est comprise entre 0 et 20 %.

4. Film poreux selon la revendication 1, dans lequel la chaleur de fusion est comprise entre 10 et 80 J/g telle que mesurée par DSC (analyse calorimétrique différentielle) à 10 ˚C/min.

5. Film poreux selon la revendication 4, dans lequel le retrait thermique est compris entre 0 et 0,7 % après traitement à 260 ˚C pendant 10 minutes.

6. Film poreux selon la revendication 1, lequel a une épaisseur comprise entre 5 et 100 $\mu$m.

7. Film poreux selon la revendication 1, lequel ne contient sensiblement pas de sel inorganique.

8. Film poreux selon la revendication 1, dans lequel la valeur de perméabilité au gaz mesurée selon JIS P8117 est comprise entre 0 et 3600 s/100 cc.

9. Procédé de production d'un film poreux selon la revendication 1, lequel est un procédé de production d'un film poreux possédant au moins deux surfaces et contenant une pluralité de pores reliés, dans lequel une solution de polymères contenant du poly(métaphénylène isophtalamide) et un solvant amide est soumise aux étapes (i) à (iv) suivantes dans l'ordre :

(i) une étape de coulée sur un support,
(ii) une étape de coagulation par immersion dans laquelle la couche de solution coulée est immergée dans une solution de coagulation amidique contenant une substance qui est non compatible avec le poly(métaphénylène isophtalamide) pour la coagulation de la couche de solution coulée, et dans laquelle la température de la solution de coagulation amidique est comprise entre -20 ˚C et +25 ˚C,
(iii) une étape de lavage et de libération dans laquelle la couche coagulée obtenue à l'étape précédente est lavée et libérée, ou libérée du support pendant le lavage, et
(iv) une étape de traitement thermique dans laquelle la couche coagulée lavée et libérée est traitée thermiquement.

10. Procédé de production d'un film poreux selon la revendication 1, lequel est un procédé de production d'un film poreux possédant au moins deux surfaces et contenant une pluralité de pores reliés, dans lequel une solution de polymères contenant du poly(métaphénylène isophtalamide), un solvant amide et au moins un composé choisi dans le groupe comprenant une substance de type alcool polyhydrique et/ou un hydro-carbure en $C_{5-19}$ qui est soluble dans une solution de coagulation amidique est soumise aux étapes (i) à (iv) suivantes dans l'ordre :

(i) une étape de coulée sur un support,
(ii) une étape de coagulation par immersion dans laquelle la couche de solution coulée est immergée dans une solution de coagulation amidique contenant une substance qui est non compatible avec le poly(métaphénylène isophtalamide) pour la coagulation de la couche de solution coulée,
(iii) une étape de lavage et de libération dans laquelle la couche coagulée obtenue à l'étape précédente est lavée et libérée, ou libérée du support pendant le lavage, et
(iv) une étape de traitement thermique dans laquelle la couche coagulée lavée et libérée est traitée thermiquement.

11. Procédé de production d'un film poreux selon la revendication 1, lequel est un procédé de production d'un film poreux possédant au moins deux surfaces et contenant une pluralité de pores reliés, dans lequel une solution de polymères contenant du poly(métaphénylène isophtalamide) et un solvant amide est soumise aux étapes (i) à (iv) suivantes dans l'ordre :

(i) une étape de coulée sur un support,
(ii) une étape de coagulation par immersion dans laquelle la couche de solution coulée est immergée dans une solution de coagulation amidique contenant une substance qui est non compatible avec le poly(métaphénylène isophtalamide) pour la coagulation de la couche de solution coulée,
(iii) une étape de lavage et de libération dans laquelle la couche coagulée obtenue à l'étape précédente est lavée et libérée, ou libérée du support pendant le lavage, et

(iv) une étape de traitement thermique dans laquelle la couche coagulée lavée et libérée est traitée thermiquement,

dans lequel la surface du support est soumise à un traitement par frottement avant que la solution de polymères ne soit coulée sur le support.

12. Procédé de production d'un film poreux selon la revendication 11, dans lequel la pression pour le traitement par frottement appliquée sur le support est comprise entre 10 et 1000 g/cm$^2$.

13. Procédé de production d'un film poreux selon l'une des revendications 9 à 11, dans lequel l'étape (ii) est suivie d'une étape d'immersion dans la solution de coagulation amidique avec la couche de solution coulée à l'état coagulé, puis d'un traitement thermique, pour la cristallisation de la couche coagulée.

14. Procédé de production d'un film poreux selon la revendication 13, dans lequel l'étape de cristallisation entraîne la contraction de la couche coagulée de 5 à 30 % en termes de rapport de section.

15. Procédé de production d'un film poreux selon les revendications 9 à 11, dans lequel la solution de coagulation amidique comprend de la N-méthyl-2-pyrrolidone et de l'eau qui est incompatible avec le poly(métaphénylène isophtalamide), et la N-méthyl-2-pyrrolidone constitue 50 à 80 % en poids de la solution de coagulation amidique totale.

16. Substrat pour boîtier électronique comprenant un film poreux selon la revendication 1 en tant que matériau de noyau.

17. Utilisation d'un film poreux selon la revendication 1 en tant que matériau de noyau d'un substrat pour boîtier électronique.

Fig. 1

Fig. 2

(a)

(b)

(c)

Fig. 3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 59014494 A
- JP 59036939 A
- JP 2001345537 A
- JP 2002111227 A
- JP 2623331 B
- JP 11250890 A
- WO 0119906 A